# EUROPEAN PATENT APPLICATION

(11) **EP 4 417 862 A1**
(43) Date of publication of application: **21.08.2024**
(21) Application number: 22881244.2
(22) Date of filing: 23.09.2022
(51) Int. Cl.: F17C 9/04, F17C 7/04, F01K 25/10, F01K 23/02, F01K 13/02, H05K 7/20, F25J 1/00

(54) **SYSTEM AND METHOD FOR MANAGING HEAT SOURCE BY USING COLD ENERGY**

(30) Priority: 13.10.2021 KR 20210135397; 26.01.2022 KR 20220011408; 30.03.2022 KR 20220039831; 14.04.2022 KR 20220046580
(71) Applicant: NXN Systems Inc., Seoul 06586 (KR)
(72) Inventor: CHOI, Sang Duck, Seoul 06285 (KR)
(74) Representative: Hoefer & Partner Patentanwälte mbB
(86) International application number: PCT/KR2022/014227
(87) International publication number: WO 2023/063615

(57) **Abstract**

According to one aspect of the present invention, there is provided a system for managing a heat source using cold energy, the system comprising: a liquefied gas storage unit configured to store a liquefied gas; a heat exchange unit configured to cause cold energy of the liquefied gas to be transferred to an intermediate medium so that a first heat exchange occurs between the liquefied gas and the intermediate medium; and a first intermediate medium storage unit configured to store the intermediate medium for which the first heat exchange has occurred, and capable of being switched from a closed state to an open state or from an open state to a closed state.

## Description

### CROSS-REFERENCE TO RELATED APPLICATION(S)

This application is a national phase of Patent Cooperation Treaty (PCT) International Application No. PCT/KR2022/014227 filed on September 23, 2022, which claims priority to Korean Patent Application Nos. 10-2021-0135397, 10-2022-0011408, 10-2022-0039831, and 10-2022-0046580 filed on October 13, 2021, January 26, 2022, March 30, 2022, and April 14, 2022, respectively. The entire contents of PCT International Application No. PCT/KR2022/014227 and Korean Patent Application Nos. 10-2021-0135397, 10-2022-0011408, 10-2022-0039831, and 10-2022-0046580 are hereby incorporated by reference.

### FIELD OF THE INVENTION

The present invention relates to a system and method for managing a heat source using cold energy.

### BACKGROUND

Liquefied gases (e.g., liquefied natural gas (LNG)) generate significant amounts of cold energy during a vaporization process, which has not been meaningfully used in an economically viable way since it is often dumped into the surrounding environment.

In recent years, as the economic value of the cold energy from the liquefied gases has been recognized, various attempts have been made to harness the cold energy, and the number of sources of demand has grown significantly.

Meanwhile, in order to efficiently supply the cold energy from the liquefied gases to the sources of demand, the time of generation of the cold energy and the time of demand for the cold energy should be coincide, and the supply of the cold energy should match the demand for the cold energy at that time.

However, the current state of the art has been severely limited in meeting these conditions, resulting in large amounts of unused cold energy being wasted.

### SUMMARY OF THE INVENTION

One object of the present invention is to solve all the above-described problems in the prior art.

Another object of the invention is to efficiently supply cold energy from a liquefied gas to a demand source (e.g., a heat source such as a data center) by eliminating a mismatch between when the cold energy is generated from the liquefied gas and when the demand source requires the cold energy.

The representative configurations of the invention to achieve the above objects are described below.

According to one aspect of the invention, there is provided a system for managing a heat source using cold energy, the system comprising: a liquefied gas storage unit configured to store a liquefied gas; a heat exchange unit configured to cause cold energy of the liquefied gas to be transferred to an intermediate medium so that a first heat exchange occurs between the liquefied gas and the intermediate medium; and a first intermediate medium storage unit configured to store the intermediate medium for which the first heat exchange has occurred, and capable of being switched from a closed state to an open state or from an open state to a closed state.

According to another aspect of the invention, there is provided a method performed in a system for managing a heat source using cold energy, the system comprising a liquefied gas storage unit, a heat exchange unit, and a first intermediate medium storage unit, and the method comprising the steps of: by the liquefied gas storage unit, storing a liquefied gas; by the heat exchange unit, causing cold energy of the liquefied gas to be transferred to an intermediate medium so that a first heat exchange occurs between the liquefied gas and the intermediate medium; and by the first intermediate medium storage unit, storing the intermediate medium for which the first heat exchange has occurred, wherein the first intermediate medium storage unit is capable of being switched from a closed state to an open state or from an open state to a closed state.

In addition, there are further provided other methods and systems to implement the invention.

According to the invention, it is possible to efficiently supply cold energy from a liquefied gas to a demand source (e.g., a heat source such as a data center) by eliminating a mismatch between when the cold energy is generated from the liquefied gas and when the demand source requires the cold energy.

### BRIEF DESCRIPTION OF THE DRAWINGS

FIGS. 1 to 3 illustratively show a heat source management system according to one embodiment of the invention.
FIGS. 4 and 5 illustratively show a process of interworking a heat source management system with a heat source according to one embodiment of the invention.
FIG. 6 illustratively shows a case where the heat source in FIG. 4 is a power generation facility.
FIG. 7 illustratively shows a case where the heat source in FIG. 5 is a power generation facility.
FIG. 8 illustratively shows a heat source management system including a secondary loop according to one embodiment of the invention.
FIG. 9 illustratively shows a heat source management system excluding a power generation unit according to one embodiment of the invention.

### DETAILED DESCRIPTION OF THE PREFERRED EMBODIMENTS

In the following detailed description of the present invention, references are made to the accompanying drawings that show, by way of illustration, specific embodiments in which the invention may be practiced. These embodiments are described in sufficient detail to enable those skilled in the art to practice the invention. It is to be understood that the various embodiments of the invention, although different from each other, are not necessarily mutually exclusive. For example, specific shapes, structures and characteristics described herein may be implemented as modified from one embodiment to another without departing from the spirit and scope of the invention. Furthermore, it shall be understood that the positions or arrangements of individual elements within each embodiment may also be modified without departing from the spirit and scope of the invention. Therefore, the following detailed description is not to be taken in a limiting sense, and the scope of the invention is to be taken as encompassing the scope of the appended claims and all equivalents thereof. In the drawings, like reference numerals refer to the same or similar elements throughout the several views.

A liquefied gas as used herein refers to a gas liquefied by cooling a gas in a gaseous state at a very low temperature, and may encompass liquefied natural gas (LNG), liquefied hydrogen, liquefied nitrogen, liquefied oxygen, and the like.

Further, an intermediate medium as used herein refers to a substance that is used to transfer cold energy of a liquefied gas to a predetermined target (e.g., a heat source) or to generate electrical energy, and may encompass carbon dioxide, R125a, propane, and the like.

Furthermore, a heat source as used herein refers to a source that generates heat, and may encompass a data center (e.g., a hyperscale data center or an edge data center), power plant, steel mill, fuel cell, and the like.

Hereinafter, various preferred embodiments of the invention will be described in detail with reference to the accompanying drawings to enable those skilled in the art to easily implement the invention.

### Configuration of a heat source management system

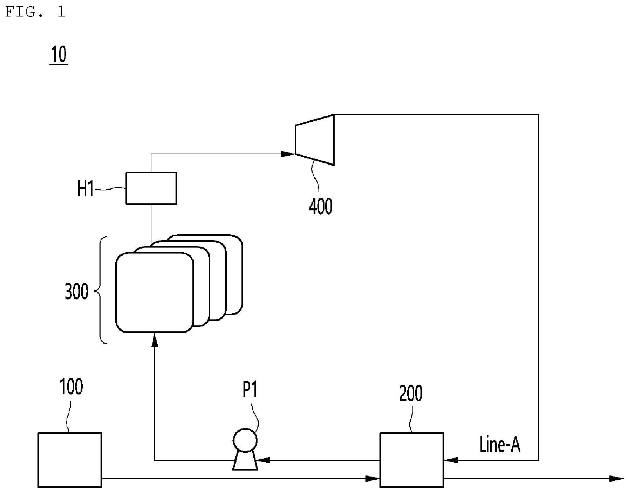

FIGS. 1 to 3 illustratively show a heat source management system 10 according to one embodiment of the invention.

Referring to FIG. 1, the heat source management system 10 according to one embodiment of the invention may comprise a liquefied gas storage unit 100, a heat exchange unit 200, a first intermediate medium storage unit 300, and a power generation unit 400.

First, the liquefied gas storage unit 100 according to one embodiment of the invention may function to store a liquefied gas.

Specifically, according to one embodiment of the invention, a liquefied gas stored at a remote location (e.g., an LNG terminal) may be transported to the liquefied gas storage unit 100 using a transportation means (e.g., a tanker truck), and the liquefied gas storage unit 100 may store the liquefied gas transported by the transportation means. Further, the liquefied gas storage unit 100 according to one embodiment of the invention may ensure that the temperature of the liquefied gas stored therein is maintained at a constant temperature.

Next, the heat exchange unit 200 according to one embodiment of the invention may function to cause cold energy of the liquefied gas to be transferred to an intermediate medium so that a first heat exchange occurs between the liquefied gas and the intermediate medium.

Specifically, the heat exchange unit 200 according to one embodiment of the invention may cause a first heat exchange to occur between a liquefied gas supplied from the liquefied gas storage unit 100 and an intermediate medium used to generate electrical energy in the power generation unit 400 (or an intermediate medium for which a second heat exchange with a heat source H1 has occurred). Here, the heat exchange unit 200 according to one embodiment of the invention may cause the cold energy generated by vaporization of the liquefied gas to be transferred to the intermediate medium, and cause the intermediate medium to be liquefied by absorbing the cold energy. That is, the heat exchange unit 200 according to one embodiment of the invention may cause the first heat exchange to occur between the liquefied gas and the intermediate medium so that the liquefied gas is vaporized and the intermediate medium is liquefied.

Next, the first intermediate medium storage unit 300 according to one embodiment of the invention may function to temporarily store the intermediate medium for which the first heat exchange has occurred.

Specifically, according to one embodiment of the invention, the intermediate medium for which the first heat exchange has occurred in the heat exchange unit 200 (i.e., the intermediate medium in a liquid state) may be moved to the first intermediate medium storage unit 300 by operation of a pump P1, and stored inside the first intermediate medium storage unit 300.

According to one embodiment of the invention, the first intermediate medium storage unit 300 may be switched from a closed state to an open state at a first time point (e.g., when the second heat exchange is required or when use of the intermediate medium is required to generate electrical energy), thereby causing the intermediate medium to move from the inside to the outside. Here, according to one embodiment of the invention, at the time when the intermediate medium moves from (or comes out of) the inside to the outside of the first intermediate medium storage unit 300, the intermediate medium may be in a liquid state or a gaseous state.

Further, according to one embodiment of the invention, the first intermediate medium storage unit 300 may be switched from the open state to the closed state at a second time point (e.g., when the second heat exchange is completed or when a third or fourth heat exchange to be described later is required), thereby preventing the intermediate medium from moving from the inside to the outside.

Meanwhile, according to one embodiment of the invention, the first intermediate medium storage unit 300 may be formed in plurality. In this case, according to one embodiment of the invention, the intermediate medium may be distributed and stored in the plurality of first intermediate medium storage units 300, thereby preventing the pressure of the intermediate medium from rising excessively.

Next, the power generation unit 400 according to one embodiment of the invention may function to generate electrical energy using the intermediate medium for which the second heat exchange with the heat source H1 has occurred.

First, according to one embodiment of the invention, in response to the first intermediate medium storage unit 300 being switched to the open state, the intermediate medium may come out of the first intermediate medium storage unit 300 and move to the power generation unit 400. According to one embodiment of the invention, the heat source H1 may be present on a path along which the intermediate medium moves from the first intermediate medium storage unit 300 to the power generation unit 400, and the second heat exchange may occur between the heat source H1 and the intermediate medium.

Here, according to one embodiment of the invention, at the time when the intermediate medium comes from the inside to the outside of the first intermediate medium storage unit 300 as described above, the intermediate medium may be in a liquid state or a gaseous state, wherein the intermediate medium in the liquid state may be vaporized by absorbing heat transferred from the heat source H1 in the second heat exchange process, and the intermediate medium in the gaseous state may have an increase in temperature (i.e., remain in the gaseous state with its temperature increasing) by absorbing the heat transferred from the heat source H1 in the second heat exchange process. That is, according to one embodiment of the invention, the intermediate medium that has undergone the second heat exchange process may be in a gaseous state at high pressure (wherein the gaseous state may include a supercritical state).

According to one embodiment of the invention, the heat source H1 may be cooled as the second heat exchange with the intermediate medium occurs, and the specific process by which the heat source H1 is cooled will be described later.

Then, the power generation unit 400 according to one embodiment of the invention may generate electrical energy using the intermediate medium that has undergone the second heat exchange process (i.e., the intermediate medium in a gaseous state at high pressure). Here, the power generation unit 400 according to one embodiment of the invention may be a power generation facility that operates using the highpressure gaseous intermediate medium as a working fluid, and may be at least partially similar to a conventional turbine.

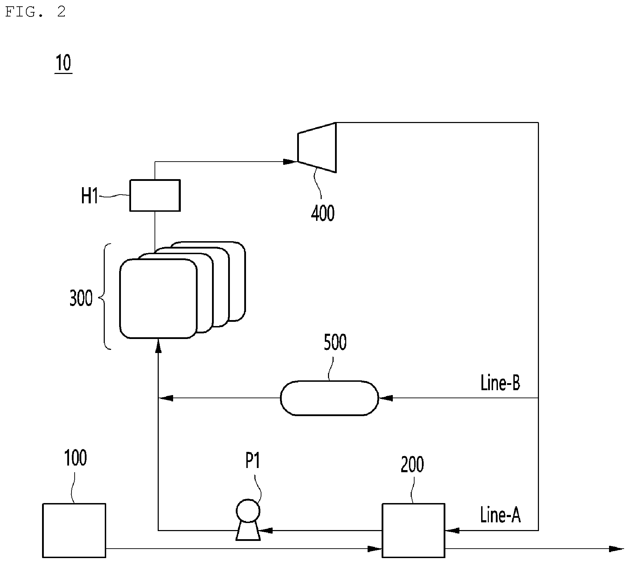

Meanwhile, referring to FIG. 2, the heat source management system 10 according to one embodiment of the invention may further comprise a liquefaction unit 500.

The liquefaction unit 500 according to one embodiment of the invention may function to compress and liquefy the intermediate medium for which the second heat exchange with the heat source H1 has occurred (or the intermediate medium used to generate electrical energy in the power generation unit 400).

According to one embodiment of the invention, the heat exchange unit 200 may also function to liquefy the intermediate medium for which the second heat exchange with the heat source H1 has occurred (or the intermediate medium used to generate electrical energy in the power generation unit 400), but the heat exchange unit 200 liquefies the intermediate medium by causing cold energy of the liquefied gas to be transferred to the intermediate medium, while the liquefaction unit 500 liquefies the intermediate medium by compressing it.

Meanwhile, according to one embodiment of the invention, the heat exchange unit 200 and the liquefaction unit 500 may be disposed on different paths. For example, for a path A (or Line-A) and a path B (or Line-B) branching from the power generation unit 400, the heat exchange unit 200 may be disposed on the path A (or Line-A) and the liquefaction unit 500 may be disposed on the path B (or Line-B). According to one embodiment of the invention, the liquefaction unit 500 may operate to liquefy the intermediate medium when there is insufficient cold energy to liquefy the intermediate medium in the heat exchange unit 200, or when the cost of power to operate the liquefaction unit 500 is relatively low. Here, according to one embodiment of the invention, the liquefaction unit 500 may liquefy the intermediate medium alone in the above cases, but may also liquefy the intermediate medium in conjunction with the heat exchange unit 200.

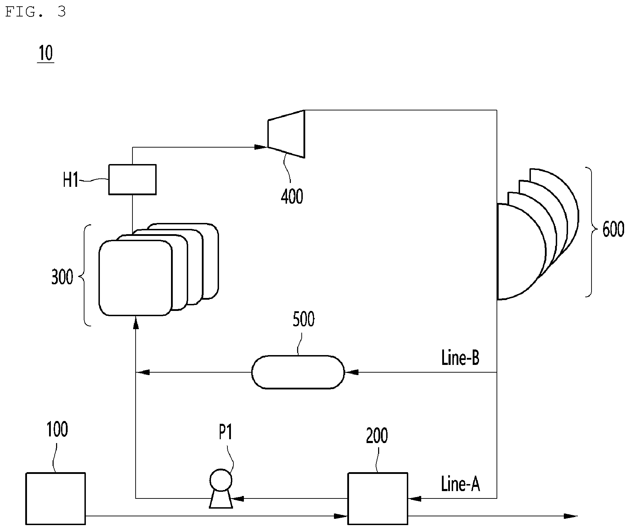

Meanwhile, referring to FIG. 3, the heat source management system 10 according to one embodiment of the invention may further comprise a second intermediate medium storage unit 600.

The second intermediate medium storage unit 600 according to one embodiment of the invention may function to temporarily store the intermediate medium for which the second heat exchange with the heat source H1 has occurred (or the intermediate medium used to generate electrical energy in the power generation unit 400) prior to liquefaction of the intermediate medium.

Specifically, the second intermediate medium storage unit 600 according to one embodiment of the invention may temporarily store the intermediate medium for which the second heat exchange has occurred (or the intermediate medium used to generate electrical energy in the power generation unit 400) before the intermediate medium is liquefied in at least one of the heat exchange unit 200 and the liquefaction unit 500.

According to one embodiment of the invention, the second intermediate medium storage unit 600 may be switched from a closed state to an open state at a predetermined time point (e.g., when the cold energy required to liquefy the intermediate medium in the heat exchange unit 200 is available, or when the cost of power to liquefy the intermediate medium in the liquefaction unit 500 is not greater a predetermined level), thereby causing the intermediate medium to move from the inside to the outside. Here, according to one embodiment of the invention, at the time when the intermediate medium moves from (or comes out of) the inside to the outside of the second intermediate medium storage unit 600, the intermediate medium may be in a gaseous state.

Meanwhile, the second intermediate medium storage unit 600 according to one embodiment of the invention may be formed in a structure that can be inflated as the intermediate medium is injected (e.g., a balloon), and may be formed in plurality as necessary.

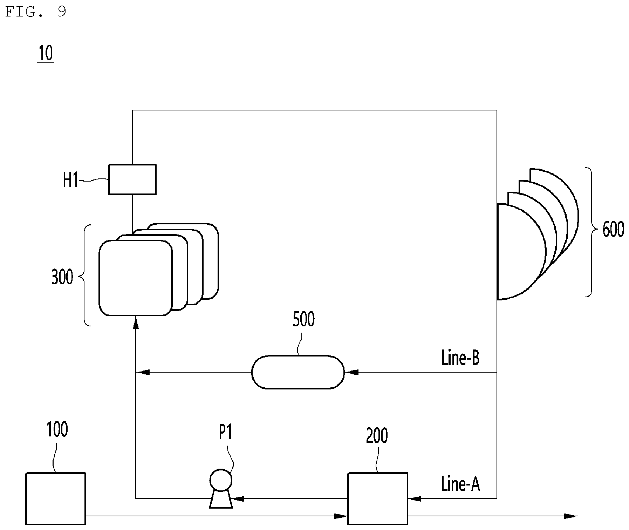

Meanwhile, although the configurations of the heat source management system 10 according to one embodiment of the invention have been described above, there may be cases where the heat source management system 10 may operate normally even if any of the above configurations are excluded according to one embodiment of the invention. For example, referring to FIG. 9, it may be assumed that the power generation unit 400 according to one embodiment of the invention is excluded from the heat source management system 10. In this case, according to one embodiment of the invention, the heat source management system 10 may operate normally except that the process of generating electrical energy using the intermediate medium for which the second heat exchange with the heat source H1 has occurred is omitted. Here, according to one embodiment of the invention, the intermediate medium for which the second heat exchange with the heat source H1 has occurred may be directly stored in the second intermediate medium storage unit 600. That is, according to one embodiment of the invention, it should be understood that there may be cases where the heat source management system 10 operates normally even if any of the configurations are excluded from the heat source management system 10.

### First embodiment

Hereinafter, it will be discussed in detail how to cool the heat source H1 and generate electrical energy by the heat source management system 10 according to one embodiment of the invention.

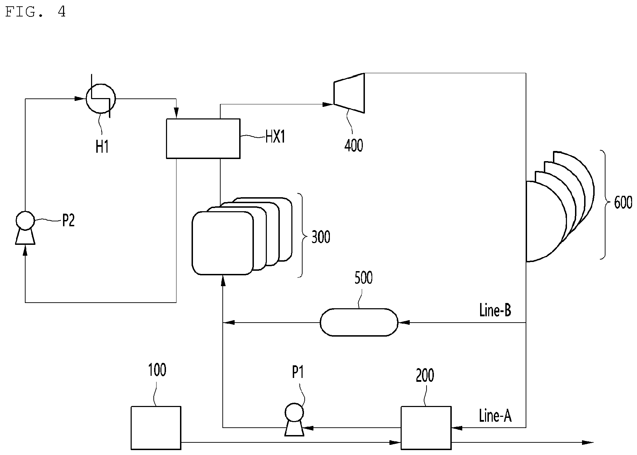

FIG. 4 illustratively shows a process of interworking the heat source management system 10 with the heat source H1 according to one embodiment of the invention.

Referring to FIG. 4, the heat source management system 10 and the heat source H1 may interwork with each other using a first auxiliary heat exchange unit HX1 disposed between the first intermediate medium storage unit 300 and the power generation unit 400, and the heat source H1 and the intermediate medium may exchange heat with each other in the first auxiliary heat exchange unit HX1 (i.e., the above-described second heat exchange).

More specifically, first, the heat source management system 10 according to one embodiment of the invention may cause the liquefied gas stored in the liquefied gas storage unit 100 and the intermediate medium used to generate electrical energy in the power generation unit 400 (or the intermediate medium stored in the second intermediate medium storage unit 600) to move to the heat exchange unit 200, respectively.

Then, the heat source management system 10 according to one embodiment of the invention may cause the first heat exchange to occur in the heat exchange unit 200 between the liquefied gas and the intermediate medium. Here, according to one embodiment of the invention, cold energy generated by vaporization of the liquefied gas may be transferred to the intermediate medium, and the intermediate medium may be liquefied by absorbing the cold energy.

Then, the heat source management system 10 according to one embodiment of the invention may cause the intermediate medium (i.e., the intermediate medium in a liquid state) for which the first heat exchange has occurred to move to the first intermediate medium storage unit 300 by operation of the pump P1, and may cause the intermediate medium to be stored inside the first intermediate medium storage unit 300.

Then, the heat source management system 10 according to one embodiment of the invention may cause the second heat exchange between the heat source H1 and the intermediate medium moving from the first intermediate medium storage unit 300 to the power generation unit 400 to occur in the first auxiliary heat exchange unit HX1. Specifically, the heat source management system 10 according to one embodiment of the invention may cause the second heat exchange to occur between a heat medium in which the heat generated by the heat source H1 is stored (e.g., water or glycol) and the intermediate medium.

Here, according to one embodiment of the invention, at the time when the intermediate medium moves from (or comes out of) the inside to the outside of the first intermediate medium storage unit 300, the intermediate medium may be in a liquid state or a gaseous state, wherein the intermediate medium in the liquid state may be vaporized by absorbing heat transferred from the heat source H1 (more specifically, the heat medium in which the heat generated by the heat source H1 is stored) in the second heat exchange process, and the intermediate medium in the gaseous state may have an increase in temperature (i.e., remain in the gaseous state with its temperature increasing) by absorbing the heat transferred from the heat source H1 in the second heat exchange process. That is, according to one embodiment of the invention, the intermediate medium that has undergone the second heat exchange process may be in a gaseous state at high pressure (wherein the gaseous state may include a supercritical state).

Meanwhile, according to one embodiment of the invention, the heat medium may have a decrease in temperature as it undergoes the second heat exchange process, and the heat medium whose temperature has decreased may cool the heat source H1. Here, according to one embodiment of the invention, circulation of the heat medium between the heat source H1 and the first auxiliary heat exchange unit HX1 may be achieved by operation of a pump P2.

Further, according to one embodiment of the invention, the heat medium in which the heat generated by the heat source H1 is stored may be temporarily stored in a thermal energy storage facility (e.g., a thermal energy storage (TES); not shown), wherein the heat medium may be moved from the thermal energy storage facility to the first auxiliary heat exchange unit HX1 at the time when the second heat exchange process is initiated.

Then, the heat source management system 10 according to one embodiment of the invention may use the intermediate medium that has undergone the second heat exchange process (i.e., the intermediate medium in a gaseous state at high pressure) to generate electrical energy in the power generation unit 400.

Then, the heat source management system 10 according to one embodiment of the invention may cause the intermediate medium used to generate electrical energy in the power generation unit 400 to be stored in the second intermediate medium storage unit 600.

Here, the heat source management system 10 according to one embodiment of the invention may terminate one cycle of cooling the heat source H1 and generating electrical energy by storing the intermediate medium in the second intermediate medium storage unit 600, or may terminate the above cycle by liquefying the intermediate medium supplied from the second intermediate medium storage unit 600 in at least one of the heat exchange unit 200 and the liquefaction unit 500 and storing the liquefied intermediate medium in the first intermediate medium storage unit 300.

Meanwhile, although not shown in the drawings, the heat source management system 10 may further interwork with a compact heat source (which may be a heat source that is different from the heat source H1 and generates a relatively less amount of heat than the heat source H1) (e.g., an edge data center) using the first intermediate medium storage unit 300. Here, the heat source management system 10 according to one embodiment of the invention may cause a heat exchange to occur between the intermediate medium and the compact heat source in a state in which the intermediate medium is stored in the first intermediate medium storage unit 300 (i.e., a state in which the first intermediate medium storage unit 300 is in a closed state). Specifically, the heat source management system 10 according to one embodiment of the invention may cause a heat exchange to occur between a heat medium in which the heat generated by the compact heat source is stored (e.g., water or glycol) and the intermediate medium. According to one embodiment of the invention, the heat source management system 10 may further cool the compact heat source through the above heat exchange process.

### Second embodiment

Hereinafter, it will be discussed in detail how to cool the heat source H1 and generate electrical energy by the heat source management system 10 according to one embodiment of the invention.

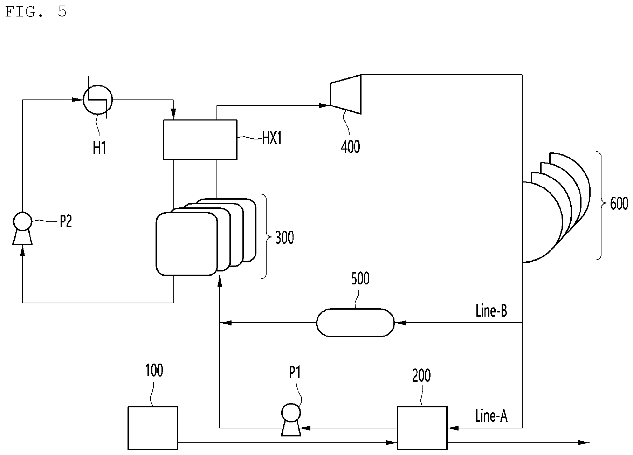

FIG. 5 illustratively shows a process of interworking the heat source management system 10 with the heat source H1 according to one embodiment of the invention.

Referring to FIG. 5, the heat source management system 10 and the heat source H1 may interwork with each other using the first intermediate medium storage unit 300 and the first auxiliary heat exchange unit HX1 disposed between the first intermediate medium storage unit 300 and the power generation unit 400, and the heat source H1 and the intermediate medium may exchange heat in the first auxiliary heat exchange unit HX1 (i.e., the above-described second heat exchange), and may also exchange heat in the first intermediate medium storage unit 300 (i.e., a third heat exchange to be described later).

More specifically, first, the heat source management system 10 according to one embodiment of the invention may cause the liquefied gas stored in the liquefied gas storage unit 100 and the intermediate medium used to generate electrical energy in the power generation unit 400 (or the intermediate medium stored in the second intermediate medium storage unit 600) to move to the heat exchange unit 200, respectively.

Then, the heat source management system 10 according to one embodiment of the invention may cause the first heat exchange to occur in the heat exchange unit 200 between the liquefied gas and the intermediate medium. Here, according to one embodiment of the invention, cold energy generated by vaporization of the liquefied gas may be transferred to the intermediate medium, and the intermediate medium may be liquefied by absorbing the cold energy.

Then, the heat source management system 10 according to one embodiment of the invention may cause the intermediate medium for which the first heat exchange has occurred (i.e., the intermediate medium in a liquid state) to move to the first intermediate medium storage unit 300 by operation of the pump P1, and may cause the intermediate medium to be stored inside the first intermediate medium storage unit 300.

Then, the heat source management system 10 according to one embodiment of the invention may cause a third heat exchange to occur between the intermediate medium and the heat source H1 in a state in which the intermediate medium is stored in the first intermediate medium storage unit 300 (i.e., a state in which the first intermediate medium storage unit 300 is closed). Specifically, the heat source management system 10 according to one embodiment of the invention may cause the third heat exchange to occur between a heat medium in which the heat generated by the heat source H1 is stored (e.g., water or glycol) and the intermediate medium.

Here, according to one embodiment of the invention, the intermediate medium stored in the first intermediate medium storage unit 300 may be in a liquid state, and the intermediate medium may have an increase in temperature (i.e., remain in the liquid state with its temperature increasing) by absorbing the heat transferred from the heat source H1 (more specifically, the heat medium in which the heat generated by the heat source H1 is stored) in the third heat exchange process.

Then, the heat source management system 10 according to one embodiment of the invention may cause the second heat exchange between the heat source H1 and the intermediate medium moving from the first intermediate medium storage unit 300 to the power generation unit 400 (i.e., the intermediate medium that has undergone the third heat exchange process) to occur in the first auxiliary heat exchange unit HX1. Specifically, the heat source management system 10 according to one embodiment of the invention may cause the second heat exchange to occur between a heat medium in which the heat generated by the heat source H1 is stored (e.g., water or glycol) and the intermediate medium, as in the third heat exchange.

Here, according to one embodiment of the invention, at the time when the intermediate medium moves from (or comes out of) the inside to the outside of the first intermediate medium storage unit 300, the intermediate medium may be in a liquid state or a gaseous state, wherein the intermediate medium in the liquid state may be vaporized by absorbing heat transferred from the heat source H1 (more specifically, the heat medium in which the heat generated by the heat source H1 is stored) in the second heat exchange process, and the intermediate medium in the gaseous state may have an increase in temperature (i.e., remain in the gaseous state with its temperature increasing) by absorbing heat transferred from the heat source H1 in the second heat exchange process. That is, according to one embodiment of the invention, the intermediate medium that has undergone the second heat exchange process may be in a gaseous state at high pressure (wherein the gaseous state may include a supercritical state).

Meanwhile, according to one embodiment of the invention, the heat medium may have a decrease in temperature as it undergoes the third heat exchange process and the second heat exchange process, and the heat medium whose temperature has decreased may cool the heat source H1. Here, according to one embodiment of the invention, circulation of the heat medium between the heat source H1 and the first intermediate medium storage unit 300 or the first auxiliary heat exchange unit HX1 may be achieved by operation of the pump P2.

Further, according to one embodiment of the invention, the heat medium in which the heat generated by the heat source H1 is stored may be temporarily stored in a thermal energy storage facility (e.g., a thermal energy storage (TES); not shown), wherein the heat medium may be moved from the thermal energy storage facility to the first intermediate medium storage unit 300 at the time when the third heat exchange process is initiated, or may be moved from the thermal energy storage facility to the first auxiliary heat exchange unit HX1 at the time when the second heat exchange process is initiated.

Then, the heat source management system 10 according to one embodiment of the invention may use the intermediate medium that has undergone the second heat exchange process (i.e., the intermediate medium in a gaseous state at high pressure) to generate electrical energy in the power generation unit 400.

Then, the heat source management system 10 according to one embodiment of the invention may cause the intermediate medium used to generate electrical energy in the power generation unit 400 to be stored in the second intermediate medium storage unit 600.

Here, the heat source management system 10 according to one embodiment of the invention may terminate one cycle of cooling the heat source H1 and generating electrical energy by storing the intermediate medium in the second intermediate medium storage unit 600, or may terminate the above cycle by liquefying the intermediate medium supplied from the second intermediate medium storage unit 600 in at least one of the heat exchange unit 200 and the liquefaction unit 500 and storing the liquefied intermediate medium in the first intermediate medium storage unit 300.

### Third embodiment

Hereinafter, it will be discussed in detail how a heat exchange (i.e., a fourth heat exchange to be described later) occurs between the intermediate medium and an external environment at room temperature in a state in which the intermediate medium is stored in the first intermediate medium storage unit 300 according to one embodiment of the invention.

According to one embodiment of the invention, the first intermediate medium storage unit 300 may store the intermediate medium in a liquid state that has undergone the first heat exchange process as described above.

The heat source management system 10 according to one embodiment of the invention may cause a fourth heat exchange to occur between the intermediate medium and the external environment at room temperature in a state in which the intermediate medium is stored in the first intermediate medium storage unit 300 (i.e., a state in which the first intermediate medium storage unit 300 is closed).

Here, according to one embodiment of the invention, the intermediate medium stored in the first intermediate medium storage unit 300 may be in a liquid state, and the intermediate medium may have an increase in temperature (i.e., remain in the liquid state with its temperature increasing) by absorbing heat transferred from the external environment at room temperature in the fourth heat exchange process.

According to one embodiment of the invention, at the time when the intermediate medium moves from (or comes out of) the inside to the outside of the first intermediate medium storage unit 300 (i.e., in a state in which the first intermediate medium storage unit 300 is open), the intermediate medium may be in a liquid, gaseous, or supercritical state. Here, the heat source management system 10 according to one embodiment of the invention may use the intermediate medium in a gaseous state (i.e., a gaseous state at high pressure) among the above states to generate electrical energy in the power generation unit 400.

That is, the heat source management system 10 according to one embodiment of the invention may cause the fourth heat exchange to occur between the intermediate medium and the external environment at room temperature to generate electrical energy, even when no heat exchange (i.e., second heat exchange or third heat exchange) occurs between the intermediate medium and the heat source H1. However, according to one embodiment of the invention, it is apparent that the fourth heat exchange between the intermediate medium and the external environment at room temperature does not only occur when no heat exchange (i.e., second heat exchange or third heat exchange) occurs between the intermediate medium and the heat source H1, but may also occur when the heat exchange (i.e., second heat exchange or third heat exchange) occurs between the intermediate medium and the heat source H1, as in the first or second embodiment.

### Fourth embodiment

Hereinafter, the cases where the heat source H1 is a power generation facility B (e.g., a power plant or fuel cell) according to one embodiment of the invention will be discussed in detail.

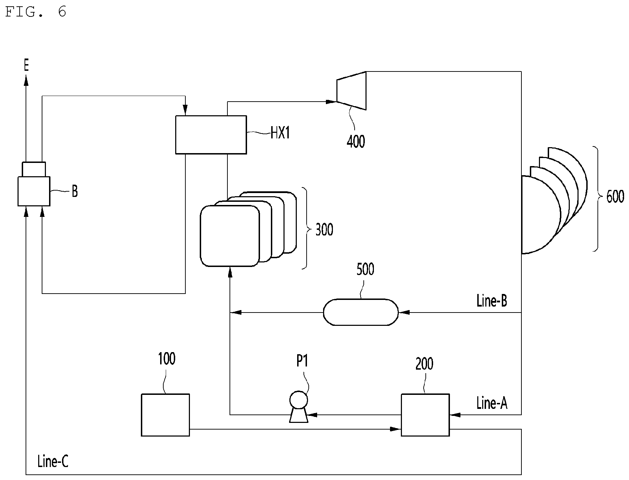

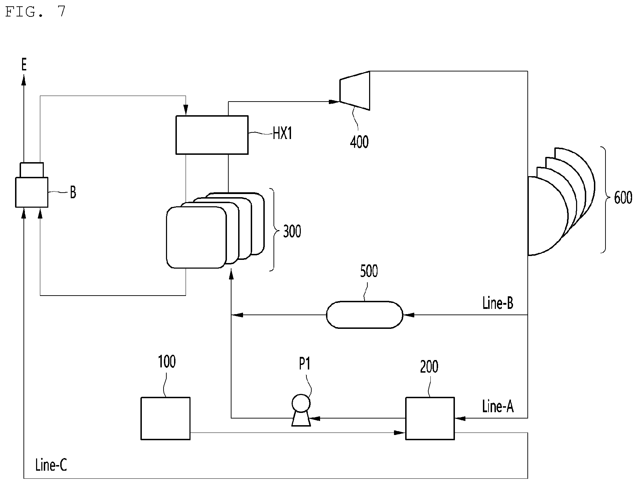

FIG. 6 illustratively shows a case where the heat source H1 in FIG. 4 is the power generation facility B, and FIG. 7 illustratively shows a case where the heat source H1 in FIG. 5 is the power generation facility B.

Referring to FIGS. 6 and 7, the heat source management system 10 according to one embodiment of the invention may cause the first heat exchange to occur between the liquefied gas and the intermediate medium in the heat exchange unit 200. Here, the heat source management system 10 according to one embodiment of the invention may cause the liquefied gas vaporized as the first heat exchange occurs to be supplied to the power generation facility B via a path C (or Line-C). According to one embodiment of the invention, the power generation facility B may receive the liquefied gas vaporized as above via the path C (or Line-C) to generate electrical energy E.

Meanwhile, according to one embodiment of the invention, heat is generated in the process of generating electrical energy E by the power generation facility B, and the heat source management system 10 may cause the heat generated as above to be transferred to the intermediate medium so that the second or third heat exchange occurs between the power generation facility B and the intermediate medium. The process of making the second or third heat exchange occur between the power generation facility B and the intermediate medium according to one embodiment of the invention is the same as the process of making the second or third heat exchange occur between the heat source H1 and the intermediate medium in the first and second embodiments, and thus a detailed description thereof will be omitted.

Meanwhile, according to one embodiment of the invention, a heat medium may be circulated between the power generation facility B and the first intermediate medium storage unit 300 or the first auxiliary heat exchange unit HX1, and the heat medium may be a flue gas discharged from the power generation facility B, or may be water, molten salt, or the like in which heat generated by the power generation facility is stored.

### Fifth embodiment

Hereinafter, one embodiment of the invention in which the heat source management system 10 comprises a secondary loop 10b will be discussed in detail. Meanwhile, it is noted that the heat source management system 10 according to this embodiment may comprise the same configurations as the heat source management system 10 previously described with reference to FIGS. 1 to 7, but some of the configurations may be omitted for ease of description.

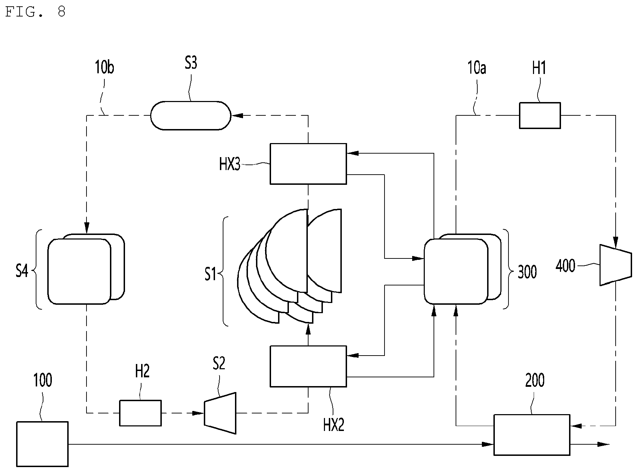

FIG. 8 illustratively shows that the heat source management system 10 comprises the secondary loop 10b according to one embodiment of the invention.

Referring to FIG. 8, a primary loop 10a and the secondary loop 10b of the heat source management system 10 may interwork with each other using a second auxiliary heat exchange unit HX2 and a third auxiliary heat exchange unit HX3 disposed, which are disposed at both ends of a third intermediate medium storage unit S1 (which performs the same function as the second intermediate medium storage unit 600), respectively.

In a state in which an intermediate medium for which the first heat exchange has occurred in the heat exchange unit 200 of the primary loop 10a is stored in the first intermediate medium storage unit 300, the heat source management system 10 according to one embodiment of the invention may cause a fifth heat exchange and a sixth heat exchange to occur between the intermediate medium and an intermediate medium circulating in the secondary loop 10b.

Specifically, in a state in which the intermediate medium for which the first heat exchange has occurred in the heat exchange unit 200 of the primary loop 10a is stored in the first intermediate medium storage unit 300, the heat source management system 10 according to one embodiment of the invention may cause the fifth heat exchange to occur between the intermediate medium and an intermediate medium used to generate electrical energy in a power generation unit S2 (which performs the same function as the power generation unit 400) of the secondary loop 10b by the second auxiliary heat exchange unit HX2.

According to one embodiment of the invention, the intermediate medium used to generate electrical energy in the power generation unit S2 of the secondary loop 10b may have a decrease in volume along with a decrease in temperature as it undergoes the fifth heat exchange process, thereby maximizing the space efficiency of the third intermediate medium storage unit S1.

Further, in a state in which the intermediate medium for which the first heat exchange has occurred in the heat exchange unit 200 of the primary loop 10a is stored in the first intermediate medium storage unit 300, the heat source management system 10 according to one embodiment of the invention may cause the sixth heat exchange to occur between the intermediate medium and an intermediate medium moving from the third intermediate medium storage unit S1 to a liquefaction unit S3 (which performs the same function as the liquefaction unit 500) by the third auxiliary heat exchange unit HX3.

According to one embodiment of the invention, the intermediate medium moving from the third intermediate medium storage unit S1 to the liquefaction unit S3 may have a decrease in volume along with a decrease in temperature as it undergoes the sixth heat exchange process, thereby minimizing heat loss during the process of compressing the intermediate medium in the liquefaction unit S3.

Meanwhile, according to one embodiment of the invention, the intermediate medium liquefied in the liquefaction unit S3 may be stored in a fourth intermediate medium storage unit S4 (which performs the same function as the first intermediate medium storage unit 300), and may exchange heat with the heat source H2 and generate electrical energy in the power generation unit S2. According to one embodiment of the invention, the above processes may be readily understood from the foregoing descriptions with reference to FIGS. 1 to 7, and thus a detailed description thereof will be omitted.

Although the present invention has been described above in terms of specific items such as detailed elements as well as the limited embodiments and the drawings, they are only provided to help more general understanding of the invention, and the present invention is not limited to the above embodiments. It will be appreciated by those skilled in the art to which the present invention pertains that various modifications and changes may be made from the above description.

Therefore, the spirit of the present invention shall not be limited to the above-described embodiments, and the entire scope of the appended claims and their equivalents will fall within the scope and spirit of the invention.

## Claims

1. A system for managing a heat source using cold energy, the system comprising:
a liquefied gas storage unit configured to store a liquefied gas;
a heat exchange unit configured to cause cold energy of the liquefied gas to be transferred to an intermediate medium so that a first heat exchange occurs between the liquefied gas and the intermediate medium; and
a first intermediate medium storage unit configured to store the intermediate medium for which the first heat exchange has occurred, and capable of being switched from a closed state to an open state or from an open state to a closed state.

2. The system of Claim 1, wherein a second heat exchange occurs between the heat source and the intermediate medium for which the first heat exchange has occurred.

3. The system of Claim 2, further comprising:
a second intermediate medium storage unit configured to store the intermediate medium prior to liquefaction of the intermediate medium for which the second heat exchange has occurred.

4. The system of Claim 2, further comprising:
a power generation unit configured to generate electrical energy using the intermediate medium for which the second heat exchange has occurred.

5. The system of Claim 3, further comprising:
a liquefaction unit configured to compress and liquefy the intermediate medium for which the second heat exchange has occurred.

6. The system of Claim 5, wherein the heat exchange unit and the liquefaction unit are disposed on different paths, and
wherein the intermediate medium for which the second heat exchange has occurred is liquefied in at least one of the heat exchange unit and the liquefaction unit, and stored in the first intermediate medium storage unit.

7. The system of Claim 2, wherein the second heat exchange occurs between the intermediate medium and the heat source as the intermediate medium moves out of the first intermediate medium storage unit.

8. The system of Claim 2, wherein a third heat exchange occurs between the intermediate medium and the heat source in a state in which the intermediate medium is stored in the first intermediate medium storage unit.

9. The system of Claim 4, wherein a fourth heat exchange occurs between the intermediate medium and an external environment at room temperature in a state in which the intermediate medium is stored in the first intermediate medium storage unit, and
wherein the power generation unit is configured to generate electrical energy using the intermediate medium for which the fourth heat exchange has occurred.

10. The system of Claim 2, wherein the heat source comprises a power generation facility,
wherein the liquefied gas vaporized as the first heat exchange occurs is supplied to the power generation facility, and
wherein heat generated by the power generation facility is transferred to the intermediate medium so that the second heat exchange occurs between the power generation facility and the intermediate medium.

11. The system of Claim 2, wherein a heat medium in which heat generated by the heat source is stored is capable of being stored in a thermal energy storage facility.

12. A method performed in a system for managing a heat source using cold energy, the system comprising a liquefied gas storage unit, a heat exchange unit, and a first intermediate medium storage unit, and the method comprising the steps of:
by the liquefied gas storage unit, storing a liquefied gas;
by the heat exchange unit, causing cold energy of the liquefied gas to be transferred to an intermediate medium so that a first heat exchange occurs between the liquefied gas and the intermediate medium; and
by the first intermediate medium storage unit, storing the intermediate medium for which the first heat exchange has occurred,
wherein the first intermediate medium storage unit is capable of being switched from a closed state to an open state or from an open state to a closed state.

13. The method of Claim 12, wherein a second heat exchange occurs between the heat source and the intermediate medium for which the first heat exchange has occurred.

14. The method of Claim 13, wherein the system further comprises a second intermediate medium storage unit, and
wherein by the second intermediate medium storage unit, the intermediate medium is stored prior to liquefaction of the intermediate medium for which the second heat exchange has occurred.

15. The method of Claim 13, wherein the system further comprises a power generation unit, and
wherein by the power generation unit, electrical energy is generated using the intermediate medium for which the second heat exchange has occurred.

16. The method of Claim 13, wherein the system further comprises a liquefaction unit, and
wherein by the liquefaction unit, the intermediate medium for which the second heat exchange has occurred is compressed and liquefied.

17. The method of Claim 16, wherein the heat exchange unit and the liquefaction unit are disposed on different paths, and
wherein the intermediate medium for which the second heat exchange has occurred is liquefied in at least one of the heat exchange unit and the liquefaction unit, and stored in the first intermediate medium storage unit.

18. The method of Claim 13, wherein the second heat exchange occurs between the intermediate medium and the heat source as the intermediate medium moves out of the first intermediate medium storage unit.

19. The method of Claim 13, wherein a third heat exchange occurs between the intermediate medium and the heat source in a state in which the intermediate medium is stored in the first intermediate medium storage unit.

20. The method of Claim 15, wherein a fourth heat exchange occurs between the intermediate medium and an external environment at room temperature in a state in which the intermediate medium is stored in the first intermediate medium storage unit, and
wherein electrical energy is generated by the power generation unit using the intermediate medium for which the fourth heat exchange has occurred.

21. The method of Claim 13, wherein the heat source comprises a power generation facility, and
wherein the liquefied gas vaporized as the first heat exchange occurs is supplied to the power generation facility, and
wherein heat generated by the power generation facility is transferred to the intermediate medium so that the second heat exchange occurs between the power generation facility and the intermediate medium.

22. The method of claim 13, wherein a heat medium in which heat generated by the heat source is stored is capable of being stored in a thermal energy storage facility.
